Europäisches Patentamt

European Patent Office

Office européen des brevets

(19)

(11) Veröffentlichungsnummer : **0 132 661**
**B1**

(12) **EUROPÄISCHE PATENTSCHRIFT**

(45) Veröffentlichungstag der Patentschrift : 06.05.87

(51) Int. Cl.⁴ : **H 03 K 17/945**, H 01 H 21/28

(21) Anmeldenummer : 84107910.6

(22) Anmeldetag : 06.07.84

(54) **Initiator für einen kontaktlosen Schalter.**

(30) Priorität : 22.07.83 DE 3326401

(43) Veröffentlichungstag der Anmeldung : 13.02.85 Patentblatt 85/07

(45) Bekanntmachung des Hinweises auf die Patenterteilung : 06.05.87 Patentblatt 87/19

(84) Benannte Vertragsstaaten : CH DE FR GB IT LI

(56) Entgegenhaltungen : EP-A- 0 015 497

(73) Patentinhaber : Siemens Aktiengesellschaft Berlin und München
Wittelsbacherplatz 2
D-8000 München 2 (DE)

(72) Erfinder : Stebegg, Josef
Prechtler Strasse 3
A-4020 Linz/Donau (AT)
Erfinder : Miek, Wolfgang
Föhrenweg 6
D-8450 Amberg (DE)

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

Beschreibung

Die Erfindung bezieht sich auf einen Initiator für einen kontaktlosen Schalter mit einem Träger- und einem Steuerteil, welchletzteres eine Betätigungsseite aufweist und in mehreren Stellungen derart an der ihm zugekehrten Frontseite des Trägerteils anbringbar ist, daß die Betätigungsseite in einer ersten Stellung von Trägerteil abgewandt und in weiteren Stellungen mit Seitenflächen des Trägerteils gleichgerichtet ist, sowie mit einem in einer Aussparung zwischen Steuer- und Trägerteil angeordneten, als dreiseitiges Prisma ausgebildeten Befestigungsteil, wobei das Befestigungsteil als um eine zur Trägerteil-Frontseite senkrechte erste Achse drehbares Teil ausgebildet und an der Trägerteil-Frontseite befestigbar ist, und daß das Steuerteil derart umsetzbar am Befestigungsteil anbringbar ist, daß es um eine zweite, mit der ersten Achse einen spitzen Winkel bildende Achse drehbar ist.

Bei einem bekannten Initiator der obengenannten Art (DE-B-2 909 048) ist zumindest das Steuerteil am Befestigungsteil über eine in der zweiten gegenüber der ersten um 45° geneigten Achse liegenden Schraube gehalten, welche in ein schräg zur Betätigungsseite verlaufendes Mutterngewinde des Steuerteils einschraubbar ist.

Der Erfindung liegt die Aufgabe zugrunde, einen Initiator der obengenannten Art dahingehend zu verbessern, daß unter Beibehaltung der Umsetzmöglichkeiten auf Schraubverbindungen zwischen Träger-, Steuer- und Befestigungsteil verzichtet werden kann. Dies wird auf einfache Weise bei einem Initiator der obengenannten Art dadurch erreicht, daß am Trägerteil eine dem Befestigungsteil zugewandte Ecke derart abgeschrägt ist, daß nach Verdrehung des prismatischen Befestigungsteils um einen vorbestimmten Winkel um die senkrechte Achse das ebenfalls drehbar um eine Mittelachse des Befestigungsteils angeordnete Steuerteil um 180° verdrehbar und danach wieder zusammen mit dem Befestigungsteil um die senkrechte Achse verdrehbar ist.

Ein optisch guter Gesamteindruck bei einfacher Umsetzmöglichkeit ergibt sich, wenn das Trägerteil aus Unter- und Oberteil besteht und die um die senkrechte Achse verdrehbare Lagerung im Unter- oder Oberteil erfolgt, wobei ein der Abschrägung entsprechendes Einpaßteil am Ober- oder Unterteil angeformt beim Zusammenfügen von Ober- und Unterteil die Abschrägung des Trägerteils ausfüllt. Mit relativ geringer Abschrägung kann ausgekommen werden, wenn am Trägerteil dem Befestigungs- und Steuerteil zugewandt ein halsförmiges Zwischenteil angeformt ist. Eine einfache Herstellung der Drehverbindungen zwischen den einzelnen Teilen ergibt sich, wenn die Drehverbindung zwischen Steuerteil — Befestigungsteil und Befestigungsteil — Trägerteil über Schnappverbindungen vorgesehen ist. Diese sind vorzugsweise nicht lösbar. Dadurch ist keine Reservelänge der Verbindungsleitung erforderlich. Das Steuerteil ist an sich in der eingestellten Lage nach der Befestigung des Initiators an der Unterlage fest arretiert. Eine einfache Arretierung, auch bei nicht montiertem Initiator, läßt sich jedoch erreichen, wenn am die Drehverbindung zwischen Trägerteil und Befestigungsteil nicht tragenden Ober- bzw. Unterteil ein die Drehbewegung in vorbestimmten Stellungen und/oder eine Axialbewegung beim Zusammensetzen von Ober- und Unterteil blockierender Ansatz vorgesehen ist. Zur besseren Stabilität gegen Verdrehen auch bei nicht montiertem oder bei mit dem Steuerteil über die Befestigungsfläche hinausragender Montage ist es vorteilhaft, wenn an Ober- und/oder Unterteil Anformungen und/oder Ausnehmungen vorgesehen sind, deren Höhe bzw. Tiefe derart gestaltet ist, daß bei durch Anschlag begrenzter Axialverschiebung zwischen Oberteil und Steuer- und Befestigungsteil die Anformungen aus den Ausnehmungen herausgezogen sind. Um Beschädigungen des Verbindungskabels zwischen Steuerteil-Befestigungsteil bzw. Befestigungsteil-Trägerteil zu vermeiden ist es vorteilhaft, wenn Drehbegrenzungsanschläge vorgesehen sind.

Anhand der Zeichnung wird ein Ausführungsbeispiel gemäß der Erfindung beschrieben und die Wirkungsweise näher erläutert.

Es zeigen :

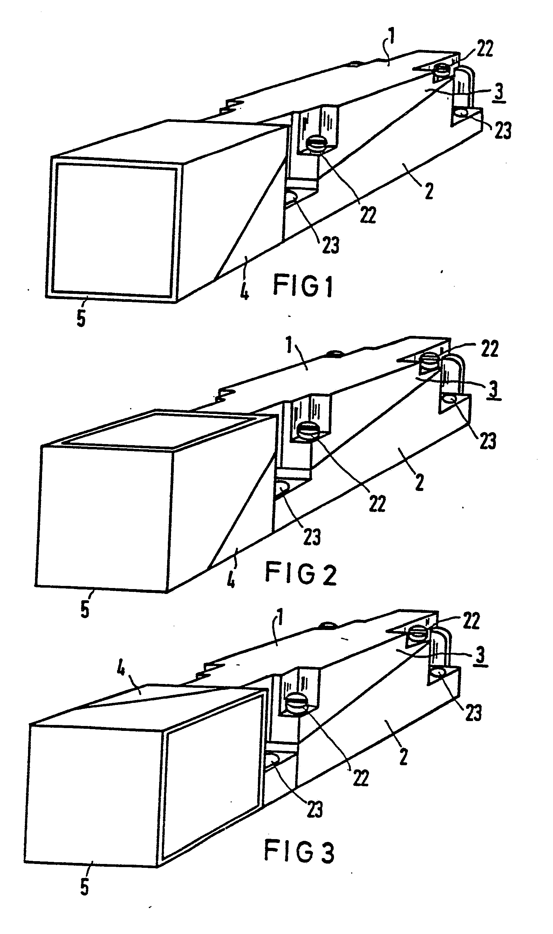

Figur 1 die perspektivische Darstellung des erfindungsgemäßen kontaktlosen Schalters mit der Sensorfläche an der Stirnseite,

Figur 2 den Schalter nach Fig. 1 mit um 180° gegenüber dem Befestigungsteil verdrehten Steuerteil,

Figur 3 den Schalter nach Fig. 1 mit gegenüber Fig. 2 gegenüber dem Trägerteil um 90° verdrehtem Befestigungs- und Steuerteil,

Figur 4 das Oberteil des Trägerteiles in perspektivischer Darstellung,

Figur 5 eine Unteransicht auf das Oberteil nach Fig. 4,

Figur 6 eine Seitenansicht auf das prismatische Befestigungsteil,

Figur 7 eine perspektivische Darstellung des Unterteils des Trägerteils,

Figur 8 eine Schnittdarstellung der Verbindung zwischen Trägerteil und Befestigungsteil und Befestigungsteil und Steuerteil,

Figur 9 eine Schnittdarstellung durch die Verbindung gemäß Fig. 8 nach der Linie IX-IX.

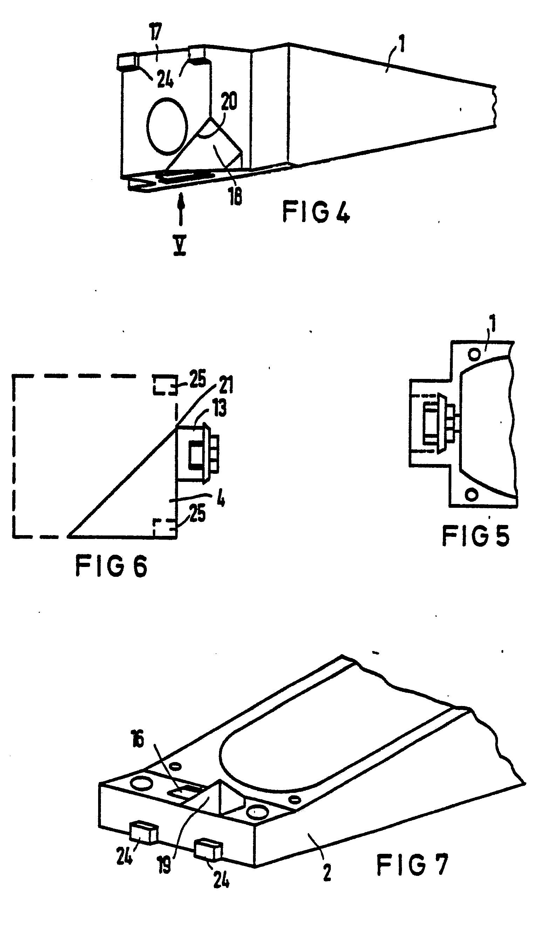

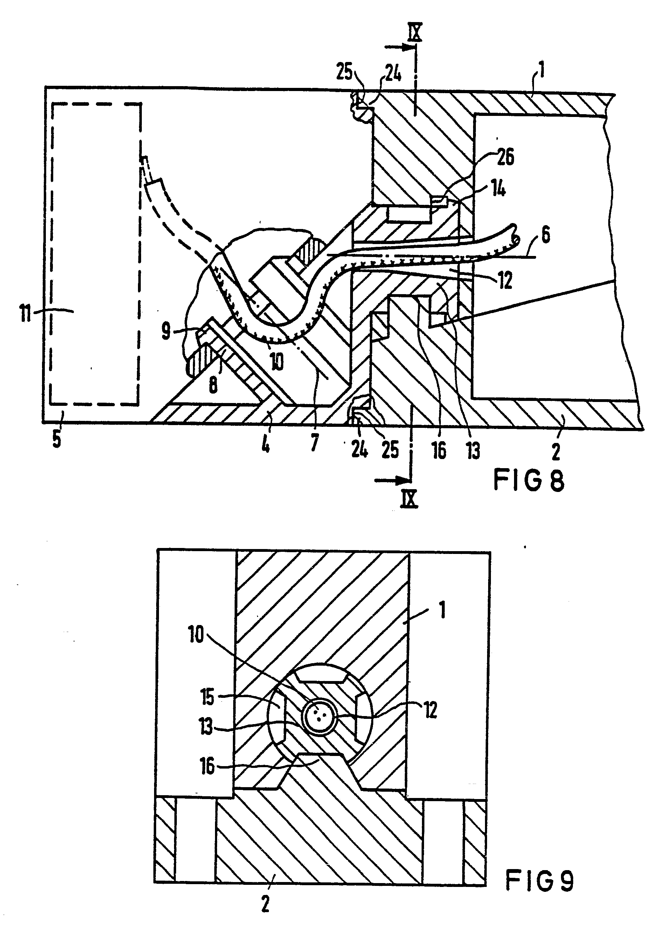

Der kontaktlose Schalter besteht aus dem aus Ober- 1 und Unterteil 2 bestehenden Trägerteil 3. Das Oberteil ist mit dem Befestigungsteil 4 und das Befestigungsteil 4 mit dem Steuerteil 5 über Schnappverbindungen, wie sie aus Fig. 8 zu ersehen sind, verbunden. Die Drehachse 6 zwischen Befestigungsteil 4 und Trägerteil 3 liegt in Längsrichtung des Trägerteilses auf deren Mittelachse. Die Drehachse 7 zwischen Steuerteil 5 und Befestigungsteil 4 liegt in einer zur Drehachse 6 um 45° geneigten Richtung, und zwar in einer Diagonale der einen quadratischen Seitenfläche des aus Steuerteil 5 und Befestigungsteil 4 gebildeten Quadrates. Das Befestigungsteil besitzt einen O-förmigen, geschlitzten Ansatz 8, der die Rasthaken 9 bildet und in dem die Verbindungsleitung 10 zwischen dem die Sensorspule 11 aufnehmenden Steuerteil 5 und dem die nicht näher dargestellte Auswerteschaltung aufnehmenden Oberteil 1 verläuft. Die Verbindungsleitung 10 ist weiterhin im Bereich der Drehachse 6 in einer ohrförmigen Aussparung 12 geführt, die in dem Drehansatz 13 am Befestigungsteil 4 eingebracht ist. Die Rasthaken zur Herstellung dieser Drehverbindung tragen das Bezugszeichen 14. Der Drehansatz 13 ist, wie Fig. 9 zeigt, mit jeweils um 90° versetzten Ausschnitten 15 versehen, in die ein am Unterteil 2 angeformter Ansatz 16 beim Zusammenfügen von Unter- und Oberteil hineinragt, und zwar derart, daß eine Verdrehung der Befestigungsteiles gegenüber dem Trägerteil 3 verhindert wird. Die Außenflächen von Befestigungsteil und Steuerteil fluchten in der blockierten Lage mit den Seitenflächen des Trägerteils 3. Es ist jedoch auch denkbar, die Blockierung beispielsweise auch in Abständen von 45° vorzusehen, so daß das Steuerteil jeweils um 45° verdreht angeordnet werden kann. Der Ansatz 16 kann auch eine Axialverschiebung zwischen Befestigungsteil 4 und Trägerteil 3 verhindern, die vorgesehen sein kann, um Anformungen 24 aus Ausnehmungen 25 herauszufahren, die im eingefahrenen Zustand eine noch bessere Drehverhinderung zwischen Befestigungsteil 4 und Trägerteil 3 bewirken sollen. Bei Wechsel der Sensorrichtung wird daher Oberteil 1 mit Steuerteil 5 und Befestigungsteil 4 von Unterteil 2 entfernt. Der Drehansatz 13 mit Steuerteil 5 und Befestigungsteil 4 wird bis zum Anschlag 26 aus dem Oberteil 2 herausgezogen und kann somit in die gewünschte Lage gedreht werden. Wie die Fig. 4 zeigt, ist am Oberteil 1 eine halsförmiges Zwischenteil 17 angeformt, an dem eine Abschrägung 18 vorgesehen ist. Am Gehäuseunterteil 2 ist ein der Abschrägung 18 angepaßtes, entsprechendes Einpaßteil 19 angeformt, so daß nach dem Zusammenfügen von Ober- und Unterteil die Abschrägung wieder ausgefüllt ist. Das Befestigungsteil 4 hat — wie Fig. 6 zeigt — prismatische Form, wobei die eine Kante mit der Längskante des Drehansatzes 13 und der Kante 20 der Abschrägung 18 zusammenläuft. Hierdurch ergibt sich die Möglichkeit, nach Verdrehen des Befestigungsteiles 4 gegenüber dem Gehäuseoberteil 1 um den Drehansatz 13, bis die Kante 21 des Befestigungsteiles 4 mit der Kante 20 der Abschrägung 18 fluchtet, das Steuerteil 5 um die Achse 7 gegenüber dem Befestigungsteil 4 zu verdrehen. Hierdurch lassen sich bei abgenommenem Oberteil die vorn dargestellten Lagen für die Sensorspule 11 erreichen, d. h. die Sensorspule 4 kann nacheinander auf alle vier Seitenflächen und die Stirnfläche gerichtet werden. Hierzu ist es lediglich notwendig, die Befestigungsschrauben 22 für das Oberteil 1 am Unterteil 2 zu lösen. Ober- und Unterteil können in bekannter Weise über Steckanschlüsse miteinander in Verbindung stehen, wobei im Unterteil 2 die Zuleitung zum Schalter eingebracht ist. Die Befestigung des Unterteils über die Befestigungsbohrungen 23 an der Montagefläche kann bei Umsetzen des Steuerteils 5 erhalten bleiben. Um die Lage des Steuerteils gegenüber dem Oberteil 1 auch bei abgenommenem Oberteil beibehalten zu können kann es vorteilhaft sein, wenn am Drehansatz 13 — nicht näher dargestellt — Rastansätze für die normalerweise üblichen vier Lagen der Sensorspule 11 vorhanden sind. Für die Verbindung zwischen Steuerteil 5 und Befestigungsteil 4 sind derartige Rastungen nicht notwendig, da die Anlage des Steuerteils 5 am halsförmigen Zwischenteil 17 eine Verdrehung lediglich in der vorbeschriebenen Stellung des Befestigungsteils 4 gegenüber dem Oberteil 1 zuläßt.

**Patentansprüche**

1. Initiator für einen kontaktlosen Schalter mit einem Träger- und einem Steuerteil, welchletzteres eine Betätigungsseite aufweist und in mehreren Stellungen derart an der ihm zugekehrten Frontseite des Trägerteils anbringbar ist, daß die Betätigungsseite in einer ersten Stellung vom Trägerteil abgewandt und in weiteren Stellungen mit Seitenflächen des Trägerteils gleichgerichtet ist, sowie mit einem in einer Aussparung zwischen Steuer- und Trägerteil angeordneten, als dreiseitiges Prisma ausgebildeten Befestigungsteil, wobei das Befestigungsteil als um eine zur Trägerteil-Frontseite senkrechte erste Achse drehbares Teil ausgebildet und an der Trägerteil-Frontseite befestigbar ist, und daß das Steuerteil derart umsetzbar am Befestigungsteil anbringbar ist, daß es um eine zweite, mit der ersten Achse einen spitzen Winkel bildende Achse drehbar ist, dadurch gekennzeichnet, daß am Trägerteil (3) eine dem Befestigungsteil (4) zugewandte Ecke derart abgeschrägt (18) ist, daß nach Verdrehung des prismatischen Befestigungsteils (4) um einen vorbestimmten Winkel um die senkrechte Achse (6) das ebenfalls drehbar um eine Mittelachse (7) des Befestigungsteils (4) angeordnete Steuerteil (5) um 180° verdrehbar und danach wieder zusammen mit dem Befestigungsteil (4) um die senkrechte Achse (6) verdrehbar ist.

2. Initiator nach Anspruch 1, dadurch gekennzeichnet, daß das Trägerteil (3) aus Unter- (2) und Oberteil (1) besteht und die um die senkrechte Achse (6) verdrehbare Lagerung im Unter- (2) oder Oberteil (1) erfolgt, wobei ein der Abschrägung (18) entsprechendes Einpaßteil (19) am Ober- (1) oder Unterteil (2) angeformt beim Zusammenfügen von Ober- (1) und Unterteil (2) die Abschrägung (18) des Trägerteils (3) ausfüllt.

3. Initiator nach Anspruch 1 oder 2, dadurch gekennzeichnet, daß am Trägerteil (3) dem Befestigungs- (4) und Steuerteil (5) zugewandt ein halsförmiges Zwischenteil (17) angeformt ist.

4. Initiator nach Anspruch 1, 2 oder 3, dadurch gekennzeichnet, daß die Drehverbindung zwischen Steuerteil (5)-Befestigungsteil (4) und Befestigungsteil (4)-Trägerteil (3) über Schnappverbindungen vorgesehen ist.

5. Initiator nach einem der Ansprüche 1 bis 4, dadurch gekennzeichnet, daß am die Drehverbindung zwischen Trägerteil (3) und Befestigungsteil (4) nicht tragenden Ober- (1) bzw. Unterteil (2) ein die Drehbewegung in vorbestimmten Stellungen und/oder eine Axialbewegung beim Zusammensetzen von Ober- (1) und Unterteil (2) blockierender Ansatz (16) vorgesehen ist.

6. Initiator nach Anspruch 5, dadurch gekennzeichnet, daß an Ober- (1) und/oder Unterteil (2) Anformungen (24) und/oder Ausnehmungen (25) vorgesehen sind, deren Höhe bzw. Tiefe derart gestaltet ist, daß bei durch Anschlag (26) begrenzter Axialverschiebung zwischen Oberteil (1) und Steuer- (5) und Befestigungsteil (4) die Anformungen (24) aus den Ausnehmungen (25) herausgezogen sind.

7. Initiator nach einem der Ansprüche 1 bis 6, dadurch gekennzeichnet, daß Drehbegrenzungsanschläge vorgesehen sind.

## Claims

1. A trigger for a contactless switch comprising a carrier component and a control component, the latter having an operating side and being fixable on the front of the carrier component, which faces said operating side, in a plurality of positions in such a manner that in a first position the operating side faces away from the carrier component and in further positions it is oriented in the same direction as lateral surfaces of the carrier component, and comprising a fastening component which is arranged in a recess between the control and carrier component and formed as a triangular prism, where the fastening component is designed as a component which is rotatable about a first axis at right angles to the front of the carrier component, and can be secured to the front of the carrier component, and that the control component can be secured to the fastening component so as to be convertible in such a manner that it can be rotated about a second axis which forms an acute angle with the first axis, characterised in that on the carrier component (3) a corner facing the fixing component (4) is chamfered (18) in such a manner that following the rotation of the prismatic fixing component (4) about the vertical axis (6) by a predetermined angle, the control component (5) which is likewise rotatably arranged about a central axis (7) of the fixing component (4), is rotatable by 180° and may be subsequently further rotated together with the fixing component (4) about the vertical axis (6).

2. A trigger as claimed in Claim 1, characterised in that the carrier component (3) consists of a lower part (2) and an upper part (1) and the mounting rotatable about the vertical axis (6) is effected in the lower part (2) or upper part (1), where a fitting component (19) corresponding to the chamfer (18) fills the chamfer (18) of the carrier component (3) so as to be attached to the upper part (1) or the lower part (2) upon assembly of the upper part (1) and the lower part (2).

3. A trigger as claimed in Claim 1 or 2, characterised in that a neck-shaped intermediate component (17) is attached to the carrier component (3) so as to face towards the fixing component (4) and the control component (5).

4. A trigger as claimed in Claim 1, 2 or 3, characterised in that the rotary connection between the control component (5)-fixing component (4) and fixing component (4)-carrier (3) is provided by means of snap connections.

5. A trigger as claimed in one of Claims 1 to 4, characterised in that an attachment (16), which blocks the rotary movement in predetermined positions and/or an axial movement upon assembly of the upper component (1) and the lower part (2), is arranged on the upper part (1) or lower part (2) which does not support the rotary connection between the carrier component (3) and the fixing component (4).

6. A trigger as claimed in Claim 5, characterised in that on the upper part (1) and/or lower part (2) are arranged attachments (24) and/or recesses (25), whose height and depth are designed to be such that the attachments (24) are drawn from the recesses (25) during axial displacement, which is limited by a stop (26), between the upper part (1) and control component (5) and fixing component (4).

7. A trigger as claimed in one of Claims 1 to 6, characterised in that there are provided rotary limiting stops.

## Revendications

1. Déclencheur pour un commutateur sans contact, avec un élément de support et un élément de commande, ce dernier comportant un côté de manœuvre et étant susceptible d'être monté de telle façon dans plusieurs positions sur le côté frontal voisin de l'élément de support que le côté manœuvre est, dans une première position, éloigné de l'élément de support, alors qu'il est, dans d'autres positions, aligné avec des surfaces latérales de l'élément de support, ainsi qu'avec un élément de fixation disposé dans un dégagement situé entre l'élément de commande et l'élément de support, et conformé à la manière d'un prisme à trois faces, l'élément de fixation étant réalisé sous la forme d'un élément susceptible de tourner autour d'un premier axe perpendiculaire au côté frontal de l'élément de support et susceptible d'être fixé au côté frontal de l'élément de support, et que l'élément de commande est susceptible d'être monté de telle manière sur l'élément de fixation, avec possibilité de changement d'emplacements, qu'il est susceptible de tourner autour d'un second axe qui forme un angle aigu avec le premier axe, caractérisé par le fait que sur l'élément de support (3), un sommet qui est situé du côté de l'élément de fixation (4) est biseauté (18) de telle façon, qu'après rotation de l'élément de fixation (4) de forme prismatique d'un angle prédéterminé autour de l'axe vertical (6), l'élément de commande (5) qui est également agencé pour pouvoir tourner autour d'un axe médian (7) de l'élément de fixation (4), est susceptible de tourner de 180° et est ensuite susceptible de tourner à nouveau avec l'élément de fixation (4), autour de l'axe vertical (6).

2. Déclencheur selon la revendication 1, caractérisé par le fait que l'élément de support (3) est constitué par une partie inférieure (2) et par une partie supérieure (1) et que le montage à rotation autour de l'axe vertical (6) a lieu dans la partie inférieure (2) ou dans la partie supérieure (1), un élément d'emboîtement (19) qui correspond au biseau (18) et conformé sur la partie supérieure (1) ou inférieure (2), comblant, lors de l'assemblage de la partie supérieure (1) et de la partie inférieure (2), le biseau (18) de l'élément de support.

3. Déclencheur selon la revendication 1 ou 2, caractérisé par le fait que sur l'élément de support (3), et du côté de l'élément de fixation (4) et de l'élément de commande (5), est conformé un élément intermédiaire (17) ayant la forme d'un cou.

4. Déclencheur selon la revendication 1, 2 ou 3, caractérisé par le fait que la liaison à rotation entre l'élément de commande (5)-l'élément de fixation (4) et l'élément de fixation (4)-l'élément de support (3), est réalisé à l'aide de liaisons à enclenchement.

5. Déclencheur selon l'une des revendications 1 à 4, caractérisé par le fait que sur la partie supérieure (1) ou la partie inférieure (2) qui ne portent pas la liaison à rotation entre l'élément de support (3) et l'élément de fixation (4), est prévu un appendice (16) bloquant le mouvement de rotation dans des positions prédéterminées et/ou un mouvement axial, lors de l'assemblage de la partie supérieure (1) et de la partie inférieure (2).

6. Déclencheur selon la revendication 5, caractérisé par le fait que sur la partie supérieure (1) et/ou sur la partie inférieure (2) sont prévus des bossages (24) et/ou des cavités (25), dont la hauteur ou la profondeur est conformée de telle façon que les bossages (24) sont dégagés des cavités (25) lors du décalage axial, limité par butée (26), entre la partie supérieure (1) et l'élément de commande (5) et l'élément de fixation (4).

7. Déclencheur selon l'une des revendications 1 à 6, caractérisé par le fait que sont prévues des butées de limitation de la rotation.

FIG 1

FIG 2

FIG 3

FIG 4

FIG 6

FIG 5

FIG 7

FIG 8

FIG 9